## Europäisches Patentamt
## European Patent Office
## Office européen des brevets

(19)

(11) Veröffentlichungsnummer: **0 290 952 B1**

# EUROPÄISCHE PATENTSCHRIFT

(12)

(45) Veröffentlichungstag der Patentschrift: **04.11.92**

(21) Anmeldenummer: **88107205.2**

(22) Anmeldetag: **05.05.88**

(51) Int. Cl.5: **H04M 9/08**, H03G 3/32, H03G 7/00

(54) **Schaltungsanordnung zur Sprachsteuerung für ein Endgerät der Nachrichtentechnik.**

(30) Priorität: **15.05.87 DE 3716246**
**23.07.87 DE 3724346**
**20.02.88 DE 3805357**

(43) Veröffentlichungstag der Anmeldung:
**17.11.88 Patentblatt 88/46**

(45) Bekanntmachung des Hinweises auf die Patenterteilung:
**04.11.92 Patentblatt 92/45**

(84) Benannte Vertragsstaaten:
**AT BE CH DE ES FR GB IT LI NL SE**

(56) Entgegenhaltungen:
**EP-A- 0 039 109**
**GB-A- 2 179 807**
**US-A- 4 240 037**
**US-A- 4 550 426**

**PATENT ABSTRACTS OF JAPAN, Band 9, Nr. 106 (E-313)[1829], 10. Mai 1985 & JP-A-59 230 356**

(73) Patentinhaber: **Standard Elektrik Lorenz Aktiengesellschaft**
**Lorenzstrasse 10**
**W-7000 Stuttgart 40(DE)**

(84) Benannte Vertragsstaaten:
**DE**

(73) Patentinhaber: **ALCATEL N.V.**
**Strawinskylaan 537 (World Trade Center)**
**NL-1077 XX Amsterdam(NL)**

(84) Benannte Vertragsstaaten:
**BE CH ES FR GB IT LI NL SE AT**

(72) Erfinder: **Walker, Michael**
**Ringstrasse 6**
**W-7066 Baltmannsweiler 2(DE)**
Erfinder: **Köhler, Günter**
**Bussardweg 7**
**W-7312 Kirchheim(DE)**

(74) Vertreter: **Brose, Gerhard et al**
**Standard Elektrik Lorenz AG Patent- und Lizenzwesen Postfach 30 09 29**
**W-7000 Stuttgart 30(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine Schaltungsanordnung zur Sprachsteuerung für ein Endgerät der Nachrichtentechnik, die folgende Merkmale aufweist:
- ein Mikrofon, das über einen Sendezweig mit einem Übertragungskanal verbunden ist,
- einen mit dem Übertragungskanal über einen Empfangszweig verbundenen Lautsprecher, und
- eine die Verstärkung der Signale im Sendezweig bestimmende Steuerung.

Eine Freisprecheinrichtung für Telefone weist eine Schaltungsanordnung zur Dynamiksteuerung der Sprachsignale auf (Elektrisches Nachrichtenwesen Band 53 (1978) Nr. 4, Seite 288 bis 293). Sie bietet dem Benutzer eine Reihe von Vorteilen: Das Gespräch kann ohne Handapparat geführt werden, was vor allem dann nützlich ist, wenn während des Gespräches Arbeiten mit der Hand zu erledigen sind (Notizen anfertigen, in Akten blättern). Der Benutzer kann sich frei im Raum bewegen, da er das Gespräch auch aus größerer Entfernung von dem Telefon führen kann. Da die Worte des fernen Gesprächsteilnehmers, des B-Teilnehmers, über den Lautsprecher wiedergegeben werden, können dritte Personen das Gespräch mithören. Diese können sich über das eingebaute empfindliche Mikrofon schließlich auch an dem Gespräch aktiv beteiligen. Diese Vorteile gewinnen bei den neuen Kommunikationstechniken, wie z.B. bei dem im Rahmen des B-ISDN-Vorhabens vorgesehenen Bildfernsprechen, eine noch größere Bedeutung.

Andererseits ergeben sich bei einer Freisprecheinrichtung aber auch zusätzliche Schwierigkeiten durch akustische und übertragungstechnische Störgrößen. Da jedes Raumgeräusch ebenso wie das gesprochene Wort von dem Freisprechmikrofon aufgenommen wird, ergibt sich im Vergleich zum Handapparat mit seiner definierten direkten Mikrofoneinsprache ein geringerer Störabstand. Dasselbe gilt auch für die Empfangsseite, da hier dem Ohr Nutzsignal und Störsignal gleichermaßen zugeführt werden.

Ein von dem B-Teilnehmer bei dem A-Teilnehmer eintreffendes Signal wird vom Lautsprecher der Fernsprecheinrichtung wiedergegeben. Es gelangt über die Luftstrecke mit einer gewissen Dämpfung auch auf das Mikrofon und von dort aus zurück zum B-Teilnehmer. Über den Sendeweg, den Empfangsweg und die Luftstrecke wird also ein geschlossener Kreis gebildet. Ist in diesem Kreis die Verstärkung V = 1/k, wobei k den Kopplungsfaktor zwischen dem Lautsprecher und dem Mikrofon darstellt, entsteht das für den Benutzer äußerst störende Rückkopplungspfeifen, das auf jeden Fall vermieden werden muß.

Die bekannte Freisprecheinrichtung weist deshalb eine Dynamik- oder Sprachsteuerung auf, durch die abhängig vom Sprachpegel die Verstärkung in den beiden Übertragungswegen geregelt wird: Eine Erhöhung der Verstärkung im Sendeweg hat eine gleich große Verminderung der Verstärkung im Empfangsweg zur Folge und umgekehrt. Abhängig von den jeweiligen Einsatzbedingungen läßt sich eine Mindestgrenze für den Sprachsteuerungshub abschätzen.

Der Erfindung liegt die Aufgabe zugrunde, eine Schaltungsanordnung zur Dynamiksteuerung zu schaffen, bei der, ohne Verminderung der Verstärkung im Empfangskreis, die größtmögliche Kreisverstärkung genutzt wird.

Diese Aufgabe wird gemäß der Erfindung durch eine Schaltungsanordnung zur Sprachsteuerung gelöst,
- bei der dem Mikrofon ein steuerbarer Dynamik-Kompander nachgeschaltet ist, in dem die von dem Mikrofon gelieferten Signalspannungen,
  A. soweit sie über einem vorgegebenen Wert liegen, auf einen einheitlichen Signalpegel komprimiert werden,
  B. soweit sie unter dem vorgegebenen Wert liegen, expandiert werden und
  C. soweit sie den vorgegebenen Wert aufweisen, maximal verstärkt werden.

Die Vorteile der durch die Erfindung ermöglichten adaptiven Dynamiksteuerung liegen insbesondere darin, daß mit ihr das vom normalen Telefon her gewohnte "Gegensprechen" erhalten bleibt, d.h., daß nicht der eine Gesprächsteilnehmer den anderen unterdrückt. Außerdem läßt sich mit der Erfindung ein hochwertiges breitbandiges und stereophones Freisprechen erreichen. Ein größerer Störabstand als üblich läßt sich mit einem einfachen und damit wirtschaftlichen Schaltungsaufbau erreichen. Befindet sich z.B. der Gesprächsteilnehmer in einem Raum mit hohem Umgebungsgeräusch, paßt er sich naturgemäß an diese Situation an, indem er einerseits lauter spricht, was jedoch durch die Schaltung ausgeregelt wird, andererseits die Wiedergabelautstärke erhöht, wodurch das übertragene Umgebungsgeräusch abgesenkt wird. Auch das Rückkopplungspfeifen wird zuverlässig vermieden.

Vorteilhafte Weiterbildungen der Erfindung ergeben sich aus den Unteransprüchen.

Im folgenden werden Ausführungsbeispiele der Erfindung anhand der Zeichnung erläutert. Es zeigen:
  Fig. 1    eine erfindungsgemäße Schaltungsanordnung zur Dynamik-Steuerung von Sprachsignalen,
  Fig. 2    ein Diagramm zur Erläuterung der Wirkungsweise der Schaltungsanordnung nach Fig. 1,

Fig. 3    ein Diagramm zur Erläuterung eines in der Schaltungsanordnung nach Fig. 1 verwendeten Entzerrers,

Fig. 4    eine zweite Ausführung einer erfindungsgemäßen Schaltungsanordnung,

Fig. 5    eine dritte Ausführung einer erfindungsgemäßen Schaltungsanordnung,

Fig. 6    eine vierte Ausführung einer erfindungsgemäßen Schaltungsanordnung mit digitaler Signalverarbeitung,

Fig. 7    eine fünfte Ausführung einer erfindungsgemäßen Schaltungsanordnung,

Fig. 8    ein Diagramm zur Erläuterung der erfindungsgemäßen Schaltungsanordnungen nach den Fig. 4 bis 7,

Fig. 9    ein weiteres zur Erläuterung der Wirkungsweise dieser erfindungsgemäßen Schaltungsanordnungen dienendes Diagramm,

Fig. 10    ein Diagramm zur Erläuterung der Wirkungsweise eines in der Schaltungsanordnung nach Fig. 7 verwendeten Spannungs-Strom-Wandlers und

Fig. 11    ein weiteres Diagramm zur Wirkungsweise der Schaltungsanordnung nach Fig. 4,

Fig. 12    eine sechste Schaltungsanordnung zur Dynamiksteuerung von Sprachsignalen,

Fig. 13    ein siebtes Beispiel einer erfindungsgemäßen Schaltungsanordnung,

Fig. 14    ein achtes Ausführungsbeispiel einer erfindungsgemäßen Schaltungsanordnung,

Fig. 15    eine schematische Darstellung der in der Umgebung einer erfindungsgemäßen Schaltungsanordnung auftretenden akustischen Signale,

Fig. 16    ein zur Erläuterung der erfindungsgemäßen Schaltungsanordnung dienendes Diagramm und

Fig. 17    ein weiteres zur Erläuterung der erfindungsgemäßen Schaltungsanordnung dienendes Diagramm.

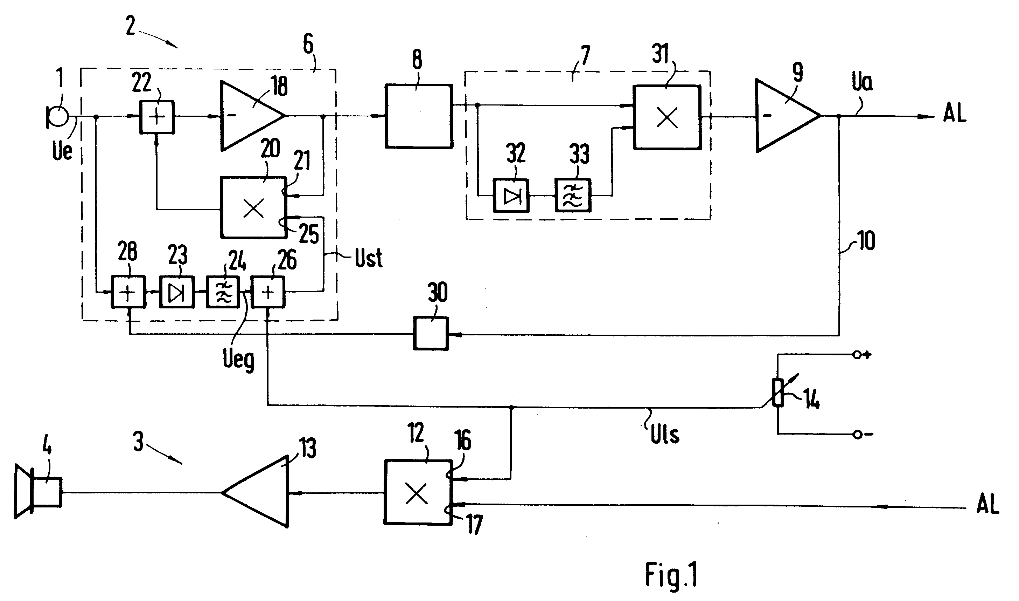

Eine Freisprecheinrichtung weist ein Mikrofon 1 auf, das über einen Sendeweg oder Sendezweig 2 mit einer - in der Zeichnung nicht dargestellten - Teilnehmer-Anschlußleitung AL verbunden ist (Fig. 1). Die Anschlußleitung AL ist ihrerseits über einen Empfangsweg oder Empfangszweig 3 mit einem Lautsprecher 4 verbunden. Im Falle einer Zweidrahtübertragung sind der Sendeweg 2 und der Empfangsweg 3 in bekannter Weise über eine Gabelschaltung mit Nachbildung an die Teilnehmer-Anschlußleitung AL anzuschließen, bei Vierdrahtübertragung können sie direkt mit dem jeweiligen Adernpaar der Anschlußleitung AL verbunden werden.

Der Sendeweg 2 enthält einen steuerbaren Dynamik-Kompressor 6, einen Dynamik-Expander 7, einen zwischen dem Kompressor 6 und dem Expander 7 liegenden Entzerrer 8 und einen Inverter 9. Einzelheiten des Kompressors 6 und des Expanders 7 werden weiter hinten erläutert. Der Inverter 9 ist als Operationsverstärker realisiert (z.B. Typ LS 404 der Firma SGS-ATES, LM 324 der Firma National Semiconductors (im folgenden NS), oder NE der Firma VALVO).

Die Ausgangssignale des Sendewegs 2 werden über eine Leitung 10, die ein Kopplungsglied 30 enthält, zu dem Kompressor 6 zurückgeführt. Der Empfangsweg 3 enthält einen Multiplizierer 12 und einen diesem nachgeschalteten Verstärker 13, dessen Ausgang mit dem Lautsprecher 4 verbunden ist. Der Multiplizierer 12 ist als Bauteil LM 13 600 der Firma NS, TDA 4292 der Firma Siemens, oder TCA 730 oder NE 572 der Firma VALVO realisiert.

Mit einer Stelleinrichtung 14 kann der Benutzer die Lautstärke der mit dem Lautsprecher 4 ausgegebenen Sprachsignale steuern. Dazu werden die Ausgangssignale der Stelleinrichtung 14 an den Steuereingang 16 des Multiplizierers 12 angelegt und bewirken in diesem die gewünschte Änderung der Amplitude oder des Pegels der zu dem Signaleingang 17 des Multiplizierers 12 gelangenden Empfangssignale. Die Ausgangssignale des Multiplizierers 12 werden in dem Verstärker 13 verstärkt und über den Lautsprecher ausgegeben.

Der Kompressor 6 enthält einen invertierenden Verstärker 18 und einen in dessen Rückführungszweig liegenden Multiplizierer 20, welche auch als ein steuerbarer Verstärker angesehen werden können. Dabei ist der Ausgang des Verstärkers 18 mit einem Signaleingang 21 des Multiplizierers 20 verbunden. Der invertierende Verstärker 18 ist ebenfalls als Operationsverstärker ausgeführt (vgl. Inverter 9), der Multiplizierer 20 als Bauteil NE 572 von VALVO oder LM 13 600 von Firma NS.

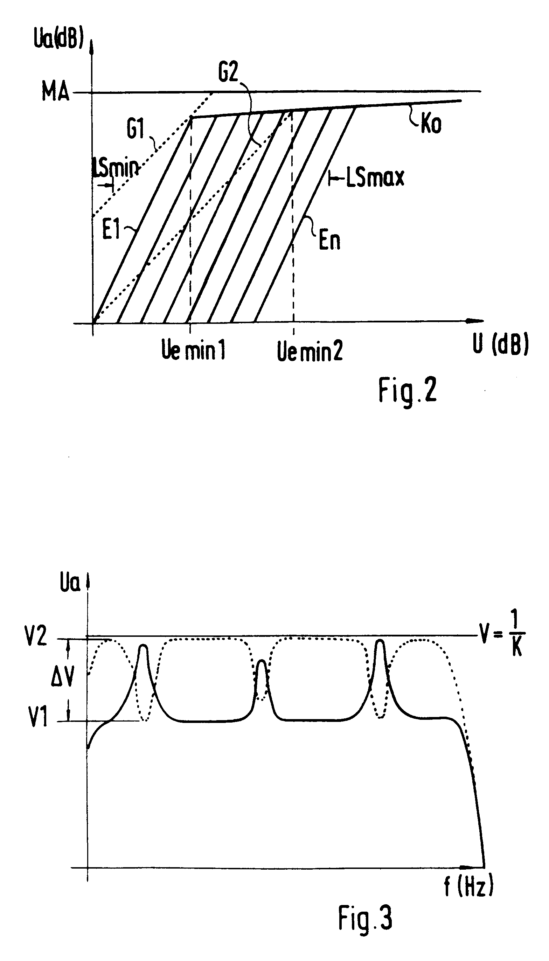

Das in dem Mikrofon 1 erzeugte Mikrofon- oder Eingangssignal Ue des Kompressors 6 gelangt einerseits über ein Addierglied 22 zu dem Eingang des Verstärkers 18 und andererseits über einen Gleichrichter 23 und einen Tiefpaß 24 zu einem Steuereingang 25 des Multiplizierers 20. Das somit gleichgerichtete und geglättete Eingangssignal entspricht dem arithmetischen Mittelwert der Eingangssignalspannung. In Abhängigkeit von diesem Mittelwert wird der Rückkopplungsfaktor für den Verstärker 18 und somit dessen Verstärkung bestimmt. Bei zunehmender Lautstärke am Mikrofon 1 und damit zunehmender Amplitude des Mikrofonssignals wird die Rückkopplung erhöht und damit die Verstärkung herabgesetzt. Hieraus ergibt sich die Signalkompression in dem Kompressor 6. Zu der Wirkungsweise des Kompressors 6 im Rahmen der erfindungsgemäßen Schaltungsanordnung siehe auch Fig. 2.

Zwischen dem Tiefpaß 24 und dem Steuereingang 25 des Multiplizierers 20 liegt ein Addierglied 26, über das das Ausgangssignal der Stelleinrichtung 14 dem Steuereingang 25 zugeführt wird. Der Wert des Lautstärke-Stellsignals bestimmt den Einsatzpunkt der Kompressionswirkung. Dabei wird dieser Einsatzpunkt so verändert, daß die resultierende Kreisverstärkung k erhalten bleibt, indem die Verstärkung des Multiplizierers 12 über den Steuereingang 16 ebenfalls verändert wird. Die im Bereich des Einsatzpunktes liegenden Signalamplituden oder -pegel - sie entsprechen der kleinsten Sprachlautstärke - werden mit dem größten Verstärkungsfaktor verstärkt, größere Signalpegel werden durch die Kompressionswirkung auf eine gleiche Signalamplitude gebracht. Oberhalb des Einsatzpunktes des Kompressors 6 wird das dem Steuereingang 25 zugeführte Steuersignal Ust durch das gleichgerichtete Mikrofonsignal Ueg bestimmt, unterhalb des Einsatzpunktes überwiegt der Einfluß des Lautstärke-Stellsignals Uls. Ohne weitere Maßnahmen ist der Übergang zwischen dem Bereich der Expansion, und dem Bereich der Kompression fließend.

Bei einer einfacheren Freisprecheinrichtung wird statt der Stelleinrichtung 14 ein fest eingestellter Widerstand verwendet, durch den die Lautstärke und der Einsatzpunkt der Kompression festgelegt sind.

Durch Rückkoppeln des Ausgangssignals Ua des Sendewegs der Freisprecheinrichtung auf den Kompressor 6 wird der Übergang von dem Expansionsbereich auf den Kompressionsbereich schmäler und schärfer gemacht. Die mit dem Ausgang des Inverters 9 verbundene Leitung 10 ist deshalb an ein weiteres Addierglied 28 angeschlossen, das vor dem Gleichrichter 23 liegt. Das Ausgangssignal Ua wird somit gleichgerichtet und geglättet und dann dem Signaleingang 25 zugeführt.

Die Leitung 10 kann ein Kopplungsnetzwerk 30 enthalten, das im Falle einer linearen Kopplung z.B. aus einem ohmschen Widerstand besteht. Realisiert man aber das Kopplungsnetzwerk mittels eines Bauteils mit gekrümmter, insbesondere exponentieller, Kennlinie, so erhält man einen ausgesprochen scharfen Übergang zwischen dem Expansions- und dem Kompressionsbereich.

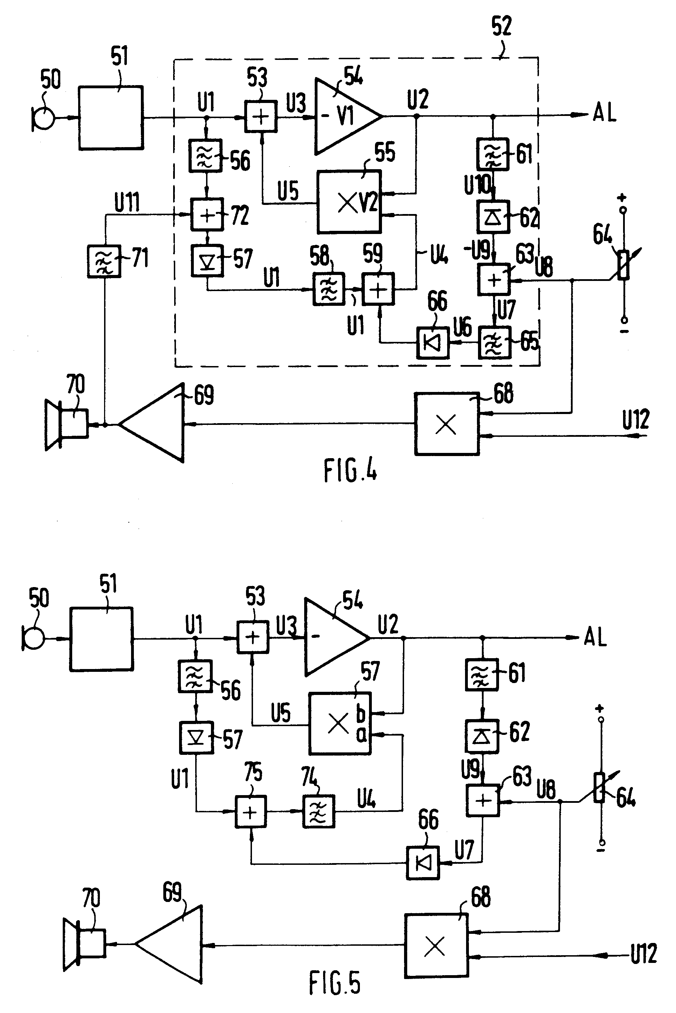

Das Ausgangssignal des Dynamik-Kompressors 6 wird dem Entzerrer 8 zugeführt, der aus einem System von Sperrfiltern besteht und in dem die Systemresonanzen der Schallwandlersysteme unterdrückt werden. In Fig. 3 ist das ungefilterte Signal mit durchgezogener Linie und die entsprechende Durchlaßkurve des Entzerrers 8 mit punktierter Linie dargestellt, und zwar in Abhängigkeit von der Frequenz. Durch das Wegfiltern der Systemresonanzen kann die Verstärkung des Nutzsignales von V1 auf V2 erhöht werden. Mit $\Delta$ V ist die maximal mögliche Erhöhung der Verstärkung dargestellt.Da die resonanzbedingten Verzerrungen unterdrückt werden, wird die Verständlichkeit des Sprachsignals erheblich verbessert. Die Sperrfilter müssen im Einzelfall in Abhängigkeit von den Eigenschaften der verwendeten Schallwandler, des Einbauortes und des Abstandes des Mikrofons zum Lautsprecher ausgelegt werden.

Von dem Entzerrer 8 gelangt das Signal zu dem Expander 7. Dieser weist einen Multipilizierer 31, einen Gleichrichter 32 und einen Tiefpaß 33 auf. Das Ausgangssignal des Entzerrers 8 gelangt einerseits direkt zu einem ersten Eingang oder Signaleingang des Multiplizierers 31 und andererseits über den Gleichrichter 32 und den Tiefpaß 33 zu dem zweiten Eingang oder Steuereingang des Multiplizierers 31. Durch diese Multiplikation des Eingangssignals mit dem entsprechenden Gleichstromwert dieses Signals werden Änderungen des Eingangssignals in dem Expander quadriert. Für die in dem Kompressor 6 auf eine einheitliche Amplitude gebrachten Nutzsignale hat der Expander 7 eine fest vorgegebene Verstärkung, die die Maximalverstärkung des Expanders darstellt. Für Signale, deren Amplitude unter dem Einsatzpunkt der Kompression liegt, nimmt aber die Verstärkung proportional mit der Abnahme der Eingangsspannung ab. D.h. Spannungen, die kleiner als das Nutzsignal sind, werden durch die Verstärkungsminderung stark herabgesetzt. Eine Eingangspegelreduzierung bewirkt eine im Quadrat größere Ausgangspegelreduzierung: $Ua2 = Ua1 \times (Ue2/Ue1)^2$, wobei Ue1, Ue2 ein erster und ein zweiter Eingangsspannungswert und Ua1, Ua2 ein erster und ein zweiter Ausgangsspannungswert sind.

Die Vorteile der adaptiven Dynamiksteuerung der Sprachsignale lassen sich anhand des Diagramms von Fig. 2 verdeutlichen, in dem die Ausgangssignalspannung Ua in Abhängigkeit von der Eingangssignalspannung Ue - jeweils in dB gemessen - dargestellt sind. Die Gesetzmäßigkeit ist für eine Freisprecheinrichtung mit konstanter Verstärkung in punktierten Linien und für die erfindungsgemäße Freisprecheinrichtung mit adaptiver Dynamiksteuerung in durchgezogenen Linien dargestellt. Bei kleiner Sprachlautstärke - Gerade G1 - kann eine große Empfindlichkeit eingestellt werden. Bei einer Freisprecheinrichtung mit pegelunabhängiger konstanter Verstärkung ist aber die maximale Aussteuergrenze MA sehr schnell erreicht, und außerdem werden die Störsignale zusammen mit den Sprachsignalen merklich verstärkt.

Bei der erfindungsgemäßen Freisprecheinrichtung hingegen werden die Eingangs- oder Mikrofonsignale, die unter dem Einsatzpunkt des Kompressors liegen, stark unterdrückt. Dieser Bereich ist durch Geraden E1 bis En dargestellt. Dabei hängt der Einsatzpunkt der Kompression und damit auch die Lage der jeweiligen Expansions-Geraden von der Stellung des Lautstärkeeinstellers 14 ab. Mit einem Pfeil LSmin ist die geringstmögliche Lautstärkeeinstellung und mit einem Pfeil LSmax die höchstmögliche Lautstärkeeinstellung gekennzeichnet. In diesem Bereich liegende Eingangssignale werden in dem Expander mit einem veränderlichen Verstärkungsgrad verstärkt, der mit abnehmender Signalamplitude immer kleiner wird, so daß die Störsignale stark unterdrückt werden. Die Verstärkung in dem Kompressor hat hier einen festen Höchstwert. Eingangssignale die über dem Einsatzpunkt des Kompressors liegen werden durch diesen auf eine nahezu konstante Ausgangsspannung zurückgeregelt - Gerade Ko -, und ergeben somit beim B-Teilnehmer eine im wesentlichen konstante Empfangslautstärke. Dabei nimmt die Verstärkung des Expanders einen festen Höchstwert an.

Bildlich gesprochen hat dies für den B-Teilnehmer die Wirkung, wie wenn mehrere die Freisprecheinrichtung des A-Teilnehmers benutzende Personen in dem gleichen Abstand von ihrem Endgerät und mit gleicher Lautstärke sprechen, während Störgeräuschquellen von dem Endgerät weit weggerückt werden. Außerdem wird damit erreicht, daß Echos bei der Gesprächsverbindung unterdrückt werden.

Zur Verarbeitung von stereofonen Signalen muß eine Freisprecheinrichtung oder ein sonstiges Gerät der Nachrichtentechnik zur Übertragung von Sprach- oder Tonsignalen - z.B. eine Lautsprecheranlage mit Rückkopplungsstrecke - mit zwei Kanälen versehen sein, d.h. die beschriebenen Schaltungsbestandteile müssen doppelt vorhanden sein.

Die aus Fig. 4 ersichtliche Schaltungsanordnung zur adaptiven Dynamiksteuerung von Sprachsignalen weist die vorteilhaften Eigenschaften der Schaltungsanordnung nach Fig. 1 auf. Es werden für sie aber weniger Bauteile benötigt, da bei ihr eine Multiplikationsschaltung eingespart wird. Die von dem Mikrophon 50 gelieferte Signalspannung gelangt zu einem Entzerrer oder Equalizer 51, in dem die weiter vorne erwähnten Systemresonanzen unterdrückt werden. Von dem Entzerrer 51 gelangt die gefilterte Mikrophonsignal- oder Eingangsspannung U1 zu einem Kompander 52, der den Kompressor 6 und den Expander 7 der Schaltungsanordnung nach Fig. 1 ersetzt. Dabei bilden eine Addierschaltung 53, ein Operationsverstärker 54 (Realisierung wie Inverter 9), ein Multiplizierer 55 (vgl. Multiplizierer 20), ein Hochpaß 56, ein Gleichrichter 57 und ein Tiefpaß 58 einen an sich bekannten Dynamik-Kompressor, der wie nachfolgend erläutert arbeitet.

Die Eingangssignalspannung U1 gelangt über die Addierschaltung 53 zu dem Operationsverstärker 54, dessen Ausgangssignal U2 über den Multiplizierer 55 auf die Addierschaltung 53 rückgeführt wird.

Die Eingangsspannung U1 gelangt außerdem über den Hochpaß 56, den Gleichrichter 57 und den Tiefpaß 58 als Spannungs-Mittelwert U4 auf den zweiten Eingang oder Steuereingang des Multiplizierers 55. Wenn über einen Addierer 59 keine weitere Spannung zugeführt wird, ist der Mittelwert von U4 gleich dem Mittelwert der Eingangsspannung U1.

Der Multiplizierer 55 bildet das Produkt aus dem Spannungs-Mittelwert U4 und der zeitlich veränderlichen Ausgangsspannung U2. Eine Erhöhung der Eingangsspannung U1 bewirkt eine proportionale Erhöhung des Verstärkungsproduktes U4 × V2. Dadurch erhöht sich die an dem Addierer 53 anliegende Gegenkopplungsspannung U5 um den gleichen Betrag wie die Eingangsspannung U1. Die - zeitlich veränderlichen - Eingangsspannung U3 und Ausgangsspannung U2 des Verstärkers 54 bleiben aber unverändert. Dies ergibt die Kompression der zu übertragenden Sprachsignale in dem Kompander 52.

Mit Hilfe der nachfolgend aufgeführten Schaltungsbestandteile wird zusätzlich der Einsatzpunkt der Kompression bestimmt und eine Dynamik-Expansion der Sprachsignale durchgeführt: einem Hochpaß 61, einem Vollweggleichrichter 62, einer Addierschaltung 63, einer Lautstärke-Stelleinrichtung 64, einem Tiefpaß 65 und einer Diode 66 (z.B. Typ 1N 4148 oder 1N 4151 von ITT).

Ab welcher Eingangsspannung U1 eine Dynamik-Kompression einsetzen soll, hängt von der Größe einer Steuerspannung U6 ab, die dem Eingang des Multiplizierers 55 über die Diode 66 und den Addierer 59 zugeführt wird. Die gemittelte Steuerspannung U6 bestimmt, sofern der Mittelwert der Eingangsspannung U1 kleiner als U6 ist, das Verstärkungsprodukt U4 · V2 des Multiplizierers 55.

Wird das Verstärkungsprodukt lediglich von einer von der Stelleinrichtung 64 vorgegebenen Gleichspannung U8 bestimmt, so ergibt sich eine konstante Verstärkung des Eingangssignals U1, dessen dynamische Schwankungen proportional auf das Ausgangssignal U2 übertragen werden.

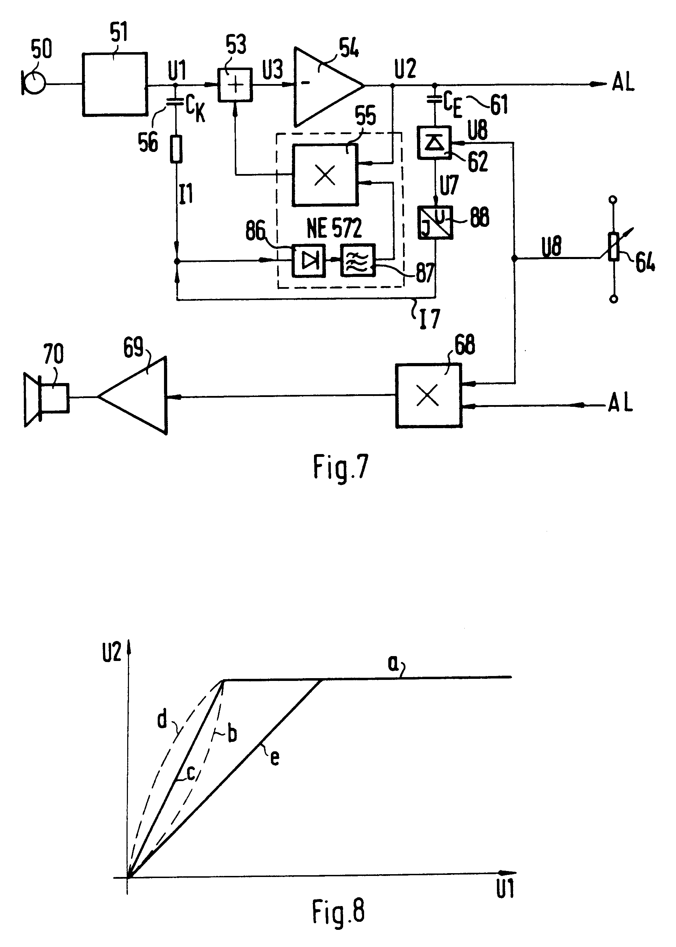

Wird die Eingangsspannung U1 größer als die Steuerspannung U6, so sperrt die Diode 66, wodurch das Verstärkungsprodukt des Multiplizierers 55 wieder von dem Eingangssignal U1 abhängig und somit die Dynamik-Kompression wirksam ist. Dieses Betriebsverhalten ist durch eine Kurve a in Fig. 8 veranschaulicht.

Die Steuerspannung U6 setzt sich aus einer von der Stelleinrichtung 64 abhängigen Gleichspannung und einer von der zeitlich veränderlichen Ausgangsspannung U2 abgeleiteten, gleichgerichteten Wechselspannung U9 zusammen. Die Ausgangsspannung U2 wird dazu durch den Hochpaß 61 von Gleichspannungsanteilen getrennt und durch den Vollweggleichrichter 62 gleichgerichtet. Dieser erzeugt eine negative Spannung -U9, deren Größe von dem Ausgangssignal U2 abhängig ist.

In der Addierschaltung 63 werden U8 und -U9 miteinander addiert. U6 stellt somit eine Steuerspannung dar, die mit zunehmender Ausgangsspannung U2 abnimmt. Über den gesamten Bereich, in dem die Eingangsspannung U1 kleiner als U6 ist, bewirkt eine Abnahme der Steuerspannung U6 = U4 eine Verringerung der Gegenkopplungsspannung U5 und damit eine Erhöhung der Ausgangsspannung U2.

Der Mittelwert der überlagerten Gleichspannung U7 wird durch den Tiefpaß 65 gebildet. Der Tiefpaß 65 bestimmt die Regelzeitkonstante für die Expansion. In dem Diagramm von Fig. 8, in dem die Ausgangsspannung U2 in Abhängigkeit von der Eingangsspannung U1 dargestellt ist, zeigt die Kurve b, daß die Expansion mit zunehmender Eingangsspannung zunimmt, da die Wirkung der gleichgerichteten Wechselspannung -U9 auf die Steuerspannung mit zunehmender Eingangsspannung U1 stärker wird. Diesem Verhalten kann entgegengewirkt werden, indem ein Vollweggleichrichter 62 mit logarithmischer Kennlinie verwendet wird.

In Abhängigkeit von der Kennlinie des Gleichrichters 62 kann die Art der Expansionszunahme festgelegt werden. Die Kurven b und d in Fig. 8 sind Beispiele hierfür. Mit Hilfe der Verstärkung des aktiven Gleichrichters 62 läßt sich die Steilheit der Expansion bestimmen (Fig. 8, Kurven c und e).

Die von der Stelleinrichtung 64 gelieferte Gleichspannung U8 ist auch an den Eingang eines Muliplizierers 68 (vgl. Multiplizierer 12) gelegt und bestimmt somit die Wiedergabelautstärke in dem Empfangszweig der Schaltungsanordnung. Dem zweiten Eingang des Muliplizierers 68 wird das von dem entfernten Gesprächsteilnehmer über die Teilnehmer-Anschlußleitung ankommende Empfangssignal U12 zugeführt. Der Ausgang des Multiplizierers 68 ist über einen Verstärker 69 mit einem Lautsprecher 70 verbunden.

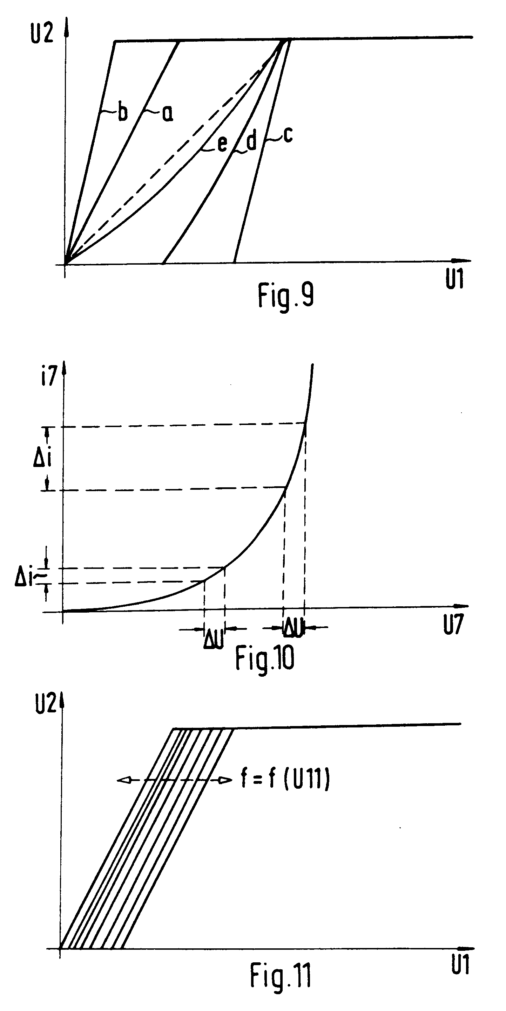

Wird die Lautstärke an der Stelleinrichtung 64 erhöht und damit die Verstärkung des Empfangssignals U12 vergrößert, so wird der Kompression-Einsatzpunkt verschoben. Dies ist in Fig. 9 durch den Abstand zwischen der Kurve c und der Kurve b verdeutlicht. Dadurch wird verhindert, daß die maximal zulässige Kreisverstärkung überschritten wird und damit eine Rückkopplung einsetzt.

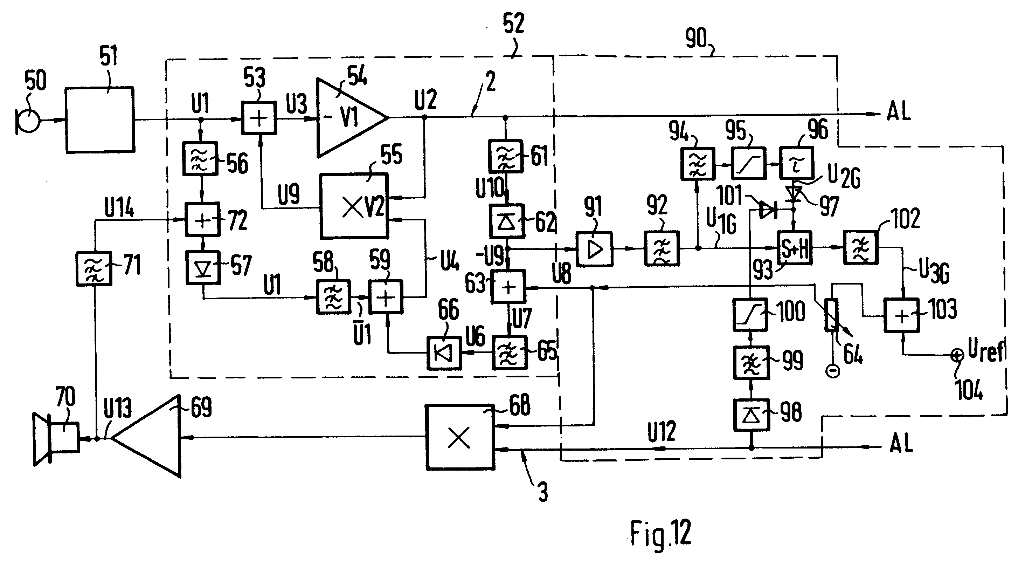

Würde man die Spannung U8 zusätzlich mit einer von der Empfangsspannung U12 abgeleiteten Größe überlagern, so könnte der Einsatzpunkt der Kompression in Abhängigkeit von den dynamischen Schwankungen des empfangenen Signals gesteuert werden. Dadurch würde die Rückkopplungsgefahr noch weiter reduziert, wobei die Wiedergabelautstärke erhöht werden könnte, und zwar um einen Betrag der der Verschiebung der Kennlinien entspricht, die in Fig. 11 angedeutet ist. Die gleiche Wirkung läßt sich erzielen, indem die Empfangsspannung - wie in der Schaltungsanordnung nach Fig. 4 realisiert - zu der Eingangsspannung U1 addiert wird. Dazu wird die Empfangsspannung U12 von dem Ausgang des Verstärkers 69 über einen Hochpaß als abgeleitete Empfangsspannung U11 einem Addierer 72 zugeführt, der zwischen dem Hochpaß 56 und dem Gleichrichter 57 liegt.

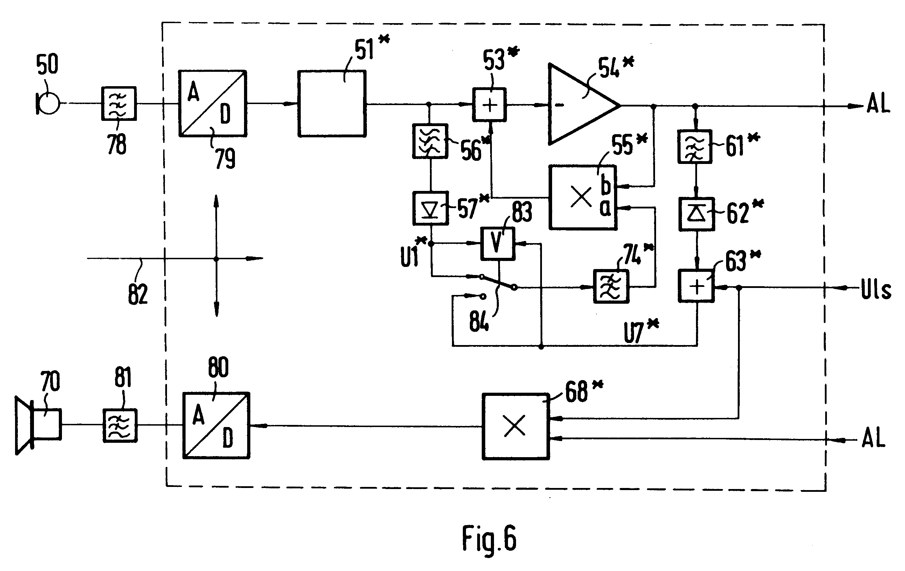

Die Regelzeitkonstanten für die Expansion und Kompression können mit Hilfe der Tiefpässe 58 und 65 unabhängig voneinander dimensioniert werden. Bei der Schaltungsanordnung nach Fig. 5 ist die Regelzeitkonstante für die Expansion und die Kompression einheitlich, sie wird von nur einem als Integrator wirkenden Tiefpaß 74 bestimmt. Hierzu werden die gleichgerichteten Wechselspannungen U1 und U7 vor der Integration in einem Addierer 75 miteinander addiert. Der weitere Aufbau und die Wirkungsweise der Schaltungsanordnung nach Fig. 5 entsprechen weitgehend der Schaltungsanordnung nach Fig. 4, sie werden deshalb nicht nochmals erläutert.

In der aus Fig. 6 ersichtlichen Schaltungsanordnung werden die Sprachsignale digital verarbeitet und übertragen. Die gestrichelt eingerahmten Schaltungsteile stimmen in ihrer Funktion weitgehend mit den entsprechenden Schaltungsteilen von Fig. 4 oder 5 überein, sie unterscheiden sich von ihnen aber dadurch, daß sie zum Verarbeiten von digitalisierten Signalen ausgelegt sind. Die digitalen Schaltungsbestandteile sind mit dem gleichen Bezugszeichen wie in Fig. 4 und 5 und zusätzlich zur Unterscheidung mit einem * versehen.

Da die Lautsprecher- und Mikrophonsignale aber weiterhin analog sind, müssen sie zunächst von bzw. in zeitdiskreten digitalen Abtastwerten umgesetzt werden. Dazu sind einige zusätzliche Bausteine erforderlich. Das Mikrophon 50 ist über ein Anti-Aliasing-Filter 78, welches Frequenzen unterdrückt, die über der halben Abtastfrequenz liegen, mit einem Analog-Digital-Wandler 79 verbunden. In dem Empfangszweig werden die über die Teilnehmer-Anschlußleitung AL empfangenen Signale in einem Digital-Analog-Wandler 80 in ein Analogsignal umgesetzt, wobei ein Tiefpaß 81 restliche Oberwellen abschneidet. Für die Verarbeitung der Signale benötigen sämtliche digitalen Bausteine Taktsignale. Dies ist in der Zeichnung durch eine Taktleitung 82 angedeutet. Die von dem Gleichrichter 57* und von der Addierschaltung 63* gelieferten Momentanwerte der Spannungen U1* bzw. U7* werden in einer Vergleichsschaltung 83 miteinander verglichen und ein Schalter 84 daraufhin so gesteuert, daß die den größeren Wert aufweisende Spannung an den Integrator 74* gelegt wird. Dies entspricht der Funktion der Diode 66 in Fig. 5 und bestimmt den Übergang von der Expansion in die Kompression. Die weitere Wirkungsweise ist dann wie anhand der vorherigen Ausführungsbeispiele bereits beschrieben.

Die aus Fig. 7 ersichtliche Schaltungsanordnung entspricht in ihrer Wirkungsweise ebenfalls den bereits beschriebenen Ausführungsbeispielen, sie ist aber mit einem auf dem Markt erhältlichen Kompander-Baustein NE 572 von VALVO realisiert. Da dieser Baustein einen Gleichrichter 86 mit Stromeingang aufweist und dessen mit einem Integrator 87 verbundener Ausgang nicht zugänglich ist, wird die überlagerte Wechselspannung U7 durch einen Spannungs-Strom-Wandler 88 in einen Steuerstrom I7 umgesetzt, welcher dann vor der Gleichrichtung des Eingangsstroms I1 zu diesem addiert wird. Der Spannungs-Strom-Wandler 88 arbeitet hierbei als Potenzierer mit einem Verhalten nach folgender Funktion:

$$I7 = EXP(U7/UT)$$

In Fig. 10 ist dieser funktionale Zusammenhang $I7 = f(U7)$ dargestellt. Eine hohe Gleichspannung U8 bewirkt auch einen hohen Gleichspannungsanteil U7 und dieser schiebt den Steuerstrom I7 in den steilen Bereich der Kurve, in dem geringe Spannungsänderungen von U7, die durch den überlagerten Wechselspannungsanteil U2 verursacht werden, zu einer steilen Expanderfunktion führen. Mit abnehmender Gleichspannung wird die Expansion abgeschwächt, wie anhand der Kurven c, d und e in Fig. 9 ersichtlich ist.

Die Verstärkung des aktiven Gleichrichters 62 bestimmt die Steilheit der Expansion. Die Gleichspannung U8 bestimmt den Arbeitspunkt des Gleichrichters 62.

Mit den erfindungsgemäßen Schaltungsanordnungen werden Störsignale bedämpft und Nutzsignale auf einen konstanten Sendepegel gebracht. Eine akustische Rückkopplung wird durch die Verschiebung des Kompressions-Einsatzpunktes auf einfache und wirksame Weise verhindert. Die beim Freisprechen häufig auftretende Halligkeit wird stark abgesenkt. Die Schaltungsanordnungen eignen sich daher sowohl im Einsatz als Freisprecheinrichtung als auch für andere Arten von Sprechschaltungen, die z.B. zur Beschallung von Hörsälen oder zur Aufnahme von akustischen Nutzsignalen, die von Störgeräuschen umgeben sind, dienen.

Wird die Lautstärke manuell eingestellt, so kann es vorkommen, daß der Teilnehmer eine höhere Wiedergabelautstärke einstellt als erforderlich. So spricht ein Gesprächsteilnehmer üblicherweise in einem Büroraum - mit einem Umgebungsgeräusch von z.B. 50 dB(A) - mit Zimmerlautstärke, d.h. mit etwa 60 dB(A). Dabei sollte die Empfangslautstärke an dem benutzten Fernsprechendgerät den gleichen Schalldruck erreichen, d.h. 60 dB(A).

Wird nun die Empfangs- oder Wiedergabelautstärke zu hoch eingestellt, kann der Einsatzpunkt der Kompression - d.h. der Zustand höchster Mikrophonempfindlichkeit - so stark verschoben werden, daß die Nutzsignale nicht mehr wie vorgesehen im Kompressionsbereich liegen. Dabei wird die Sendelautstärke für leise Sprachsilben verringert, da diese schon in den Expansionsbereich fallen.

Die aus Fig. 12 ersichtliche Schaltungsanordnung zur Dynamiksteuerung von Sprachsignalen liefert dem Teilnehmer selbstätig immer eine maximal einstellbare Lautstärke, die in etwa seiner eigenen Sprachlautstärke entspricht. Dazu wird der vorgegebene Wert der Signalspannungen, d.h. der Einsatzpunkt der Kompression, durch eine Steuerschaltung in Abhängigkeit von den Umgebungsgeräuschen eingestellt.

Da der Teilnehmer bei höherem Umgebungsgeräusch - von z.B. 60 bis 70 dB(A) - lauter spricht - mit etwa 70 bis 80 dB(A) -, kann auch der Einsatzpunkt der Kompression entsprechend der Erhöhung der Umgebungsgeräusche - d.h. mit 10 bis 20 dB(A) - verändert werden. Außerdem ist eine Erhöhung der Empfangslautstärke um den gleichen Betrag, d.h. um 10 bis 20 dB - möglich. Die Empfangslautstärke wird somit an die jeweiligen Umgebungsverhältnisse angepaßt. Die Störsignale im Sendezweig werden bei zunehmenden Umgebungsgeräusch stärker unterdrückt. Daraus ergibt sich als wesentlicher Vorteil dieser Schaltungsanordnung ein annähernd konstantes Signal-Rausch-Verhältnis oder Störabstand.

Das Mikrophon 50 ist über den Sendeweg oder Sendezweig 2 mit der - in der Zeichnung nicht weiter dargestellten - Teilnehmer-Anschlußleitung AL verbunden (Fig. 12). Die Anschlußleitung ist ihrerseits über den Empfangsweg oder Empfangszweig 3 mit dem Lautsprecher 70 verbunden. Der Sendezweig 2, der Empfangszweig 3 und der Dynamik-Kompander 52 entsprechen genau dem Ausführungsbeispiel nach Fig. 4.

Mit Hilfe der nachfolgend aufgeführten Schaltungsbestandteile wird der Einsatzpunkt der Kompression bestimmt und außerdem die Dynamik-Expansion der Sprachsignale durchgeführt: der Hochpaß 61, der Vollweggleichrichter 62, die Addierschaltung 63, der Tiefpaß 65, die Diode 66 und eine noch zu beschreibende Steuerschaltung 90, die eine Lautstärke-Stelleinrichtung 64 enthält.

Ab welcher Eingangsspannung U1 die Dynamik-Kompression einsetzen soll, hängt wie bereits erwähnt von der Größe der Steuerspannung U6 ab, die dem Eingang des Multiplizierers 55 über die Diode 66 und den Addierer 59 zugeführt wird. Die gemittelte Steuerspannung U6 bestimmt, sofern der Mittelwert der Eingangsspannung U1 kleiner als U6 ist, das Verstärkungsprodukt U4 mal V2 des Multiplizierers 55.

Wird das Verstärkungsprodukt lediglich von einer von der Steuerschaltung 90 vorgegebenen Gleichspannung U8 bestimmt, so ergibt sich eine konstante Verstärkung des Eingangssignals U1, dessen dynamische Schwankungen proportional auf das Ausgangssignal U2 übertragen werden.

Wird die Eingangsspannung U1 größer als die Steuerspannung U6, so sperrt die Diode 66, wodurch das Verstärkungsprodukt des Multiplizierers 55 wieder von dem Eingangssignal U1 abhängig und somit die Dynamik-Kompression wirksam ist.

Die Steuerspannung U6 setzt sich aus der von der Steuerschaltung 90 gelieferten Gleichspannung U8 und der von der zeitlich veränderlichen Ausgangsspannung U2 abgeleiteten, gleichgerichteten Wechselspannung U9 zusammen. Die Ausgangsspannung U2 wird dazu durch den Hochpaß 61 von Gleichspannungsanteilen getrennt und durch den Vollweggleichrichter 62 gleichgerichtet. Dieser erzeugt die negative Spannung -U9, deren Größe von dem Ausgangssignal U2 abhängig ist.

In der Addierschaltung 63 werden U8 und -U9 miteinander addiert. U6 stellt somit eine Steuerspannung dar, die einerseits mit zunehmender Ausgangsspannung U2 abnimmt und andererseits von der Höhe der von der Steuerschaltung gelieferten Gleichspannung U8 abhängt. Über den gesamten Bereich, in dem die Eingangsspannung U1 kleiner als U6 ist, bewirkt eine Abnahme der Steuerspannung U6 = U4 eine Verringerung der Gegenkopplungsspannung und damit eine Erhöhung der Ausgangsspannung U2.

Durch den Tiefpaß 65 wird der Mittelwert der sich aus der Addition ergebenden Gleichspannung U7 gebildet. Dieser Tiefpaß 65 bestimmt die Regelzeitkonstante für die Expansion.

Die von der Steuerschaltung 90 gelieferte Gleichspannung U8 liegt auch an dem Eingang des Multiplizierers 68 an und bestimmt somit die Wiedergabelautstärke in dem Empfangszweig 3 der Schaltungsanordnung. Dem zweiten Eingang des Multiplizierers 68 wird das von dem entfernten Gesprächsteilnehmer über die Teilnehmer-Anshlußleitung ankommende Empfangssignal U12 zugeführt. Der Ausgang des Multiplizierers 68 ist mit dem Verstärker 69 verbunden, von dessen Ausgang ein verstärktes Empfangssignal U13 zu dem Lautsprecher 70 gelangt. Wird die von der Steuerschaltung 90 gelieferte Gleichspannung U8 erhöht und damit die Verstärkung des Empfangssignals U12 vergrößert, so wird auch der Kompressions-Einsatzpunkt verschoben. Dadurch wird verhindert, daß die maximal zulässige Kreisverstärkung überschritten wird und eine Rückkopplung einsetzt.

Der Einsatzpunkt der Kompression wird in Abhängigkeit von den dynamischen Schwankungen des empfangenen Signals gesteuert. Dadurch wird die Rückkopplungsgefahr noch weiter reduziert, wobei die Wiedergabelautstärke erhöht werden kann, und zwar um den gleichen Betrag, um den der Kompressions-Einsatzpunkt verschoben wird. Dies wird erreicht, indem die verstärkte Empfangsspannung U13 zu der Eingangsspannung U1 addiert wird. Dazu wird die Spannung U13 von dem Ausgang des Verstärkers 69 über einen Hochpaß als abgeleitete Empfangsspannung U14 dem Addierer 72 zugeführt, der zwischen dem Hochpaß 56 und dem Gleichrichter 57 liegt.

Die Regelzeitkonstanten für die Expansion und die Kompression werden mit Hilfe der Tiefpässe 58 und 65 unabhängig voneinander dimensioniert. Die Verstärkung des aktiven Gleichrichters 62 bestimmt die Steilheit der Expansion. Die Gleichspannung U8 bestimmt den Arbeitspunkt des Gleichrichters 62.

Als Stellgröße für die Steuerschaltung 90 dient das Ausgangssignal -U9 des Gleichrichters 62, das wie erläutert die Expansionswirkung des Kompanders 52 festlegt. Dieses Signal gelangt über einen invertierenden Verstärker 91 und einen Integrator 92 als Signalspannung U1G auf den Eingang eines Abtast- und Haltegliedes 93.

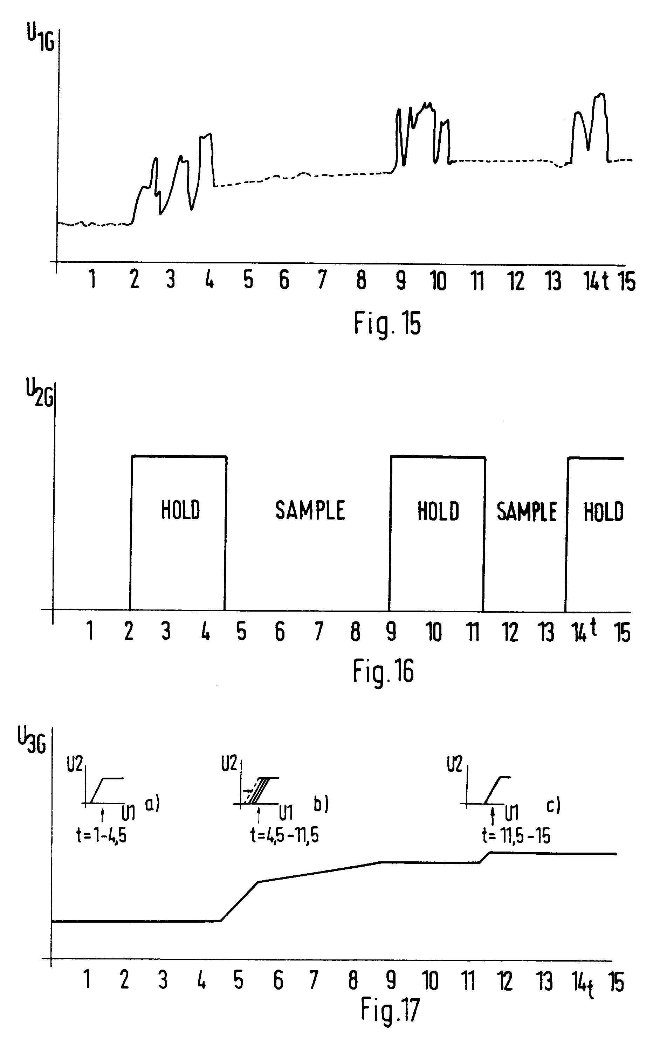

Die am Ausgang des Integrators 92 abgegebene Spannung U1G ist in Fig. 15 in ihrem zeitlichen Verlauf dargestellt. Die Darstellung entspricht einer Situation, bei der einerseits die Umgebungsgeräusche zunehmen und andererseits ein Teilnehmer spricht. Die Sprachsignale sind mit durchgehenden Linien, die Umgebungsgeräusche mit gestrichelten Linien dargestellt.

Um zu verhindern, daß die Sprachsignale eine Kennlinienverschiebung in dem Kompander 52 bewirken, wird in der Steuerschaltung ein neuer Wert der Stellgröße nur dann berücksichtigt, wenn die Spannung U1G keine starken dynamischen Schwankungen, wie sie beim Sprechen vorkommen, aufweist. Hierzu wird die Spannung U1G über einen Differenzierer 94 und eine Schwellwertschaltung 95 einem Zeitglied 96 zugeführt. Bei starken dynamischen Schwankungen verhindert ein entsprechender Impuls am Ausgang der Schwellwertschaltung 95, der in dem Zeitglied 96 verlängert wird und über eine Diode 97 an den Steuereingang des Abtast- und Haltegliedes 93 gelangt, dieses an einer Aufnahme der Signalspannung U1G solange gesprochen wird. Somit ist das Unterscheidungskriterium für die Störgeräusche in der Umgebung des Endgerätes die Kontinuität dieser Störgeräusche, die bei Sprachsignalgen nicht gegeben ist.

Da auch die empfangenen Sprachsignale, die von dem Lautsprecher 70 akustisch ausgestrahlt werden, zu einer unerwünschten Beeinflussung der Schaltungsanordnung führen würden, wird die Empfangs-Signalspannung U12 über einen Gleichrichter 98, einen Integrator 99, eine Schwellwertschaltung 100 und eine Diode 101 dem Steuereingang des Abtast- und Haltegliedes 93 zugeführt. Damit nimmt dieses auch keine neuen Werte der Signalspannung U1G auf, solange empfangene Sprachesignale ausgegeben werden. Lediglich in den Sprechpausen wird die von der Stellgröße U9 abhängige Signalspannung aufgenommen und deren Veränderungen ausgewertet.

Das Ausgangssignal des Abtast- und Haltegliedes 93 gelangt über einen Integrator 102 als Signal U3G zu einem Addierglied 103 und von diesem zu der Lautstärke-Stelleinrichtung 64, mit der der Benutzer die Lautstärke des Lautsprechers 70 von Hand einstellen kann. Von dem Ausgang der Stelleinrichtung 64 gelangt das Signal zu dem Kompander-Steuereingang, der mit der Addierschaltung 63 verbunden ist. Bei gegebener Einstellung der Stelleinrichtung 64 steuert das Signal U3G den Kompander 52, wobei die Kompanderkennlinie in Abhängigkeit von den Umgebungsgeräuschen beeinflußt wird.

Aus Fig. 16 ist ersichtlich, daß das Abtast- und Halteglied 93, gesteuert durch die an seinem Steuereingang anliegende Spannung U2G, während der Sprachpausen Meßwerte aufnimmt - SAMPLE - und daß es sich während des Gesprächs im Haltezustand - HOLD - befindet.

Die Beeinflussung der Kompanderkennlinie wird anhand von Fig. 17 erläutert, in der zum einen das Steuersignal U3G als Funktion der Zeit und zum anderen die sich aus drei verschiedenen Werten von U3G ergebenden Kompanderkennlinien in Form von eingefügten Diagrammen U2 = f(U1) dargestellt sind.

Während der Zeit t = 1 - 4,5 s ist das Umgebungsgeräusch gering und demzufolge hat das Signal U3G einen niedrigen Wert. Hier setzt die Kompression der Sprachsignale schon bei relativ niedriger Lautstärke des Teilnehmers ein. In den eingefügten Figuren ergibt sich der Einsatzpunkt der Kompression als Schnittpunkt zwischen der steilen Expansions- und der flachen Kompressionsgeraden. In Fig. 17a) liegt dieser Einsatzpunkt bei einem kleinen Wert von U1.

In der Zeit t = 4,5 bis 11,5 s steigt das Umgebungsgeräusch und damit der Pegel von U3G mehrfach mit unterschiedlicher Geschwindigkeit an. Jeder dieser Anstiege hat eine Verschiebung des Einsatzpunktes der Kompression nach rechts, d.h. zu höheren Werten des Mikrophonsignals, zur Folge, wie in Fig. 17b) durch einen Pfeil angedeutet ist.

Während der Zeit t = 11,5 bis 15 s ist das Umgebungsgeräusch sehr hoch. Der Einsatzpunkt der Kompression ist weit nach rechts verschoben, d.h. die Kompression setzt erst bei ziemlich hoher Sprachlautstärke des Teilnehmers ein - Fig. 17c).

Parallel zu der Steuerung des Kompanders 52 steuert das Signal U3G auch den Multiplizierer 68, wodurch die Wiedergabelautstärke ebenfalls selbstätig an die Umgebungsgeräusche angepaßt wird.

Von einer Referenzspannungsquelle 104 wird eine Referenzspannung Uref in dem Addierglied 103 dem Signal U3G überlagert. Diese Grundeinstellung legt die geringstmögliche Maximallautstärke fest. Mit der Stelleinrichtung 64 kann der Benutzer die gewünschte Wiedergabelautstärke einstellen, während die jeweils mögliche Maximallautstärke von der Steuerschaltung 90 vorgegeben wird.

Die anhand von Fig. 12 erläuterte Schaltungsanordnung bietet beim Einsatz im Umgebungen mit etwa konstantem Umgebungsgeräusch - wie etwa in der Wohnung, im Büro, in einem Großraumbüro oder in einer Ausstellungshalle - eine sehr zweckmäßige Ausführung der adaptiven Dynamiksteuerung.

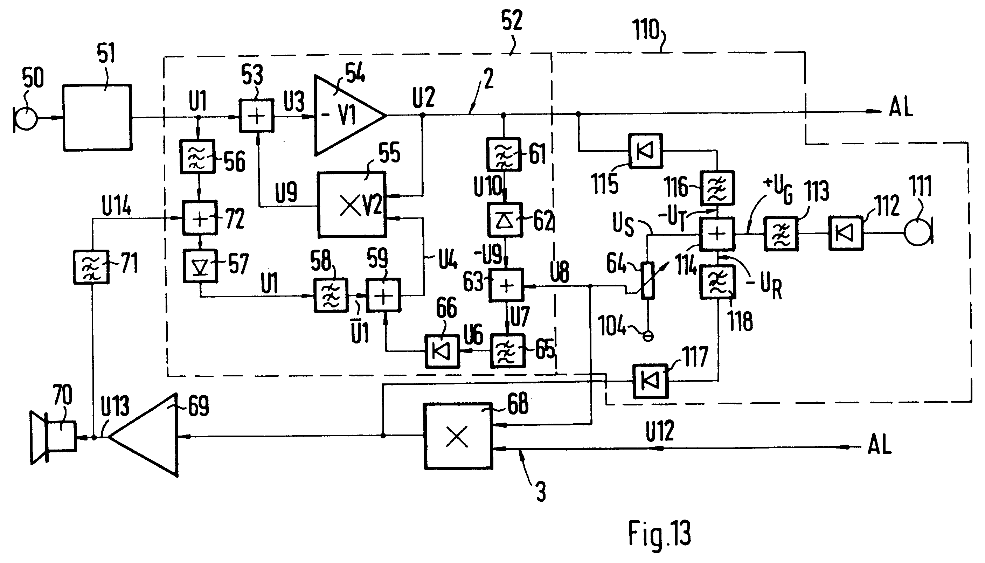

In Umgebungen mit sehr starken Geräuschschwankungen - wie z.B. Flughäfen oder Bahnhöfen - ist eine sofortige Anpassung an das Umgebungsgeräusch sinnvoll. Hier ist die aus Fig. 13 ersichtliche Schaltungsanordnung nützlich.

Die Stellgröße für die Steuerschaltung 110 wird von einem Meßmikrophon 111 geliefert, das so plaziert ist, daß hauptsächlich die Umgebungsgeräusche den am Ausgang eines Gleichrichters 112 abgegebenen Meßspannungs-Pegel bestimmen. Die Meßspannung gelangt über einen Tiefpaß 113 als integrierte Meßspannung UG zu einem Addierglied 114, in dem von dem Gesprächsteilnehmer und von dem Lautsprecher erzeugte Anteile an der Pegelerhöhung abgezogen werden. Dazu wird einmal das sendeseitige Ausgangssignal U2 über einen Gleichrichter 115 mit invertiertem Ausgangssignal an einen Tiefpaß 116 gelegt, dessen Ausgangssignal -UT auf einen Eingang des Addiergliedes 114 gegeben wird. Zum anderen wird das Empfangssignal U12 von dem Ausgang des Multiplizierers 68 über einen Gleichrichter 117 mit invertiertem Ausgangssignal an einen Tiefpaß 118 gegeben, dessen Ausgangssignal -UR ebenfalls an einen Eingang des Addiergliedes 114 gelegt wird. Somit ist das Steuersignal an dem Ausgang des Addiergliedes 114

$$US = UG - UT - UR$$

Dieses Steuersignal gelangt über die Lautstärke-Stelleinrichtung 64 zu dem Steuereingang des Kompanders 52, d.h. zu dem Addierglied 63. Auch hier kann durch eine Referenzspannungsquelle eine Grundeinstellung vorgegeben werden, die die kleinstmögiche Maximallautstärke vorgibt.

Die Steuerspannung US paßt sich kontinuierlich dem Umgebungsgeräusch an und legt entsprechend den Einsatzpunkt der Kompression und die Empfangslautstärke kontinuierlich in Abhängigkeit von dem Umgebungsgeräusch fest.

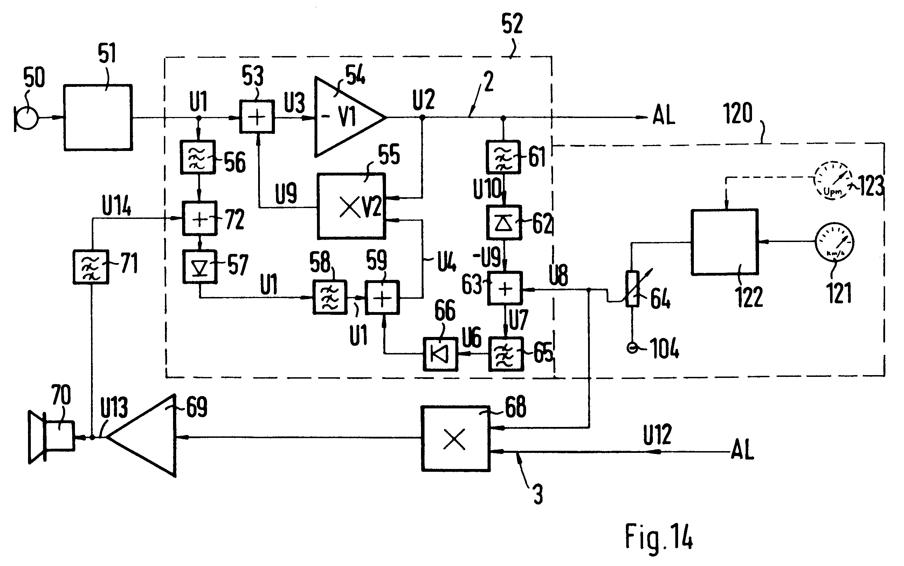

Die aus Fig. 14 ersichtliche Steuerschaltung ist für Fernsprechendgeräte geeignet, die in Kraftfahrzeugen verwendet werden. Die Geräuschentwicklung in einem Kraftfahrzeug hängt fast ausschließlich von der Fahrgeschwindigkeit ab. Die Stellgröße für die Steuerschaltung 120 wird direkt von dem Tachometer 121 des Kraftfahrzeug abgenommen. Das Ausgangssignal des Tachometers 121 wird einer Anpassungsschaltung 122 zugeführt und gelangt von dieser über die Lautstärke-Stelleinrichtung 64 als Steuersignal U8 zu der Addierschaltung 63 des Kompanders 52. Außerdem wird es dem Multiplizierer 68 zugeführt, so daß es auch die Lautstärke des Empfangssignals U12 beeinflußt. Ergänzend zu dem Tachometer 121 kann auch ein Motor-Drehzahlmesser 123 das Stellsignal für die Steuerschaltung 120 liefern. Dies ist inbesondere bei Fahrzeugen sinnvoll, bei denen das Motorgeräusch einen merklichen Beitrag zu dem Geräuschpegel in dem Fahrzeug liefert.

Die Schaltungsanordnung nach Fig. 14 erfordert geringen Aufwand, zeichnet sich aber durch hohe Zuverlässigkeit aus. Sie erhöht auch die Fahrsicherheit, da der Gesprächsteilnehmer während der Fahrt keinerlei Lautstärkekorrekturen vornehmen muß.

**Patentansprüche**

1. Schaltungsanordnung zur Dynamiksteuerung von Sprachsignalen in einem Endgerät der Nachrichtentechnik, die folgende Merkmale aufweist:
    - ein Mikrophon (50), das über einen Sendezweig mit einem übertragungskanal verbunden ist,
    - einen mit dem Übertragungskanal über einen Empfangszweig verbundenen Lautsprecher (70) und
    - eine die Verstärkung der Signale im Sendezweig bestimmende Steuerung, **dadurch gekennzeichnet,**
    - daß dem Mikrophon (50) ein steuerbarer Dynamik-Kompander (52) nachgeschaltet ist, in dem die von dem Mikrophon (50) gelieferten Signalspannungen (U1),
    A. soweit sie über einem vorgegebenen Wert (Uemin) liegen, auf einen einheitlichen Signalpegel komprimiert werden,
    B. soweit sie unter dem vorgegebenen Wert (Uemin) liegen, expandiert werden, und
    C. soweit sie den vorgegebenen Wert (Uemin) aufweisen, maximal verstärkt werden.

2. Schaltungsanordnung nach Anspruch 1, dadurch gekennzeichnet, daß der vorgegebene Wert (Uemin) der Signalspannungen mittels einer Stelleinrichtung (14, 64) festgelegt wird, mit der der Teilnehmer die Lautstärke des Lautsprechers (4, 70) steuert.

3. Schaltungsanordnung nach Anspruch 1, dadurch gekennzeichnet, daß der Dynamik-Kompander (52) einen Dynamik-Kompressor (53 bis 58) enthält, der einen Operationsverstärker (54) und einen in dessen Rückführungszweig liegenden Multiplizierer (55) aufweist, dessen Steuereingang ein Steuersignal zugeführt wird, das in Abhängigkeit von dem Pegel der Mikrophon-Signalspannung (U1) entweder durch das gleichgerichtete Mikrophonsignal (U1) oder durch eine von der Stelleinrichtung (64) gelieferte Gleichspannung (U8), der eine von der Ausgangsspannung (U2) des Kompanders (52) abgeleitete gleichgerichtete Wechselspannung (-U9) überlagert wird, bestimmt wird.

4. Schaltungsanordnung nach Anspruch 3, dadurch gekennzeichnet, daß das Ausgangssignal (U2) in einem Hochpaß (61) von seinen Gleichspannungsanteilen getrennt, in einem Vollweggleichrichter (62) gleichgerichtet und in einer Addierschaltung (63) der Gleichspannung (U8) von der Stelleinrichtung (64) überlagert wird.

5. Schaltungsanordnung nach Anspruch 4, dadurch gekennzeichnet, daß das von der Addierschaltung (63) ausgegebene Gleichspannungssignal (U7) auf einen Tiefpaß (65) gegeben wird, in dem der Mittelwert (U6) des überlagerten gleichgerichteten Wechselspannungssignals gebildet wird.

6. Schaltungsanordnung nach Anspruch 1, dadurch gekennzeichnet,
    - daß der Dynamik-Kompander aus einem Dynamik-Kompressor (6) und einem Dynamik-Expander (7) besteht,
    - daß in dem Dynamik-Kompressor (6) die von dem Mikrophon (1) gelieferten Signalspannungen, die über dem vorgegebenen Wert liegen, durch Ändern des Verstärkungsgrades auf einen einheitlichen Signalpegel komprimiert werden,

- daß die von dem Dynamik-Kompressor ausgegebenen Signale dem Dynamik-Expander (7) zugeführt werden, durch den die unter dem vorgegebenen Wert liegenden Signalspannungen mit einem Verstärkungsgrad verstärkt werden, der mit abnehmendem Signalpegel verringert wird, und

- daß der Verstärkungsgrad des Dynamik-Kompessors (6) für den vorgegebenen Wert aufweisende Signalspannungen einen Höchstwert annimmt.

7. Schaltungsanordnung nach Anspruch 6, dadurch gekennzeichnet, daß der Dynamik-Kompressor (6) einen Operationsverstärker (18) und einen in dessen Rückführungszweig liegenden Multiplizierer (20) aufweist, dessen Steuereingang (25) das gleichgerichtete Mikrophonsignal (Ue) zugeführt wird.

8. Schaltungsanordnung nach Anspruch 7, dadurch gekennzeichnet, daß der Ausgang des Sendeweges (2) über ein Kopplungsnetzwerk (30) mit einer Summierstufe (28) des Kompressors (6) verbunden ist.

9. Schaltungsanordnung nach Anspruch 8, dadurch gekennzeichnet, daß das Kopplungsnetzwerk (30) ein Glied mit exponentieller Kennlinie aufweist.

10. Schaltungsanordnung nach Anspruch 6, dadurch gekennzeichnet, daß ein die Resonanzbereiche des Schallwandlersystems (1) unterdrückender Entzerrer (8) vor dem Dynamik-Expander (7) angeordnet ist.

11. Schaltungsanordung nach Anspruch 1, dadurch gekennzeichnet,

- daß der vorgegebene Wert (Uemin) der Signalspannungen durch eine Steuerschaltung (90) in Abhängigkeit von den Umgebungsgeräuschen eingestellt wird.

12. Schaltungsanordnung nach Anspruch 11, dadurch gekennzeichnet, daß das Signal-zu-Rausch-Verhältnis des an dem Ausgang des Sendezweiges (2) abgegebenen Sprachsignals (U2) durch die Steuerschaltung (90) konstant gehalten wird.

13. Schaltungsanordnung nach Anspruch 11, dadurch gekennzeichnet, daß eine von der Ausgangsspannung (U2) des Sendewegs (2) abgeleitete, gleichgerichtete Wechselspannung (U9) als Stellgröße für die Steuerschaltung (90) dient.

14. Schaltungsanordnung nach Anspruch 13, dadurch gekennzeichnet, daß die Steuerschaltung (90) ein Abtast- und Halteglied (93) enthält, dem die gleichgerichtete Wechselspannung (U9) über ein Integrierglied (92) zugeführt wird und dessen integriertes Ausgangssignal (U3G) dem Steuereingang (63) des Dynamik-Kompanders (52) zugeführt wird.

15. Schaltungsanordnung nach Anspruch 13, dadurch gekennzeichnet, daß die Steuerschaltung (90) eine erste Sperrschaltung (94, 95, 96) enthält, die eine Aufnahme der integrierten Wechselspannung (U9) durch das Abtast- und Halteglied (93) während des Sprechens des Teilnehmers verhindert.

16. Schaltungsanordnung nach Anspruch 13, dadurch gekennzeichnet, daß die Steuerschaltung (90) eine zweite Sperrschaltung (98, 99, 100) enthält, die eine Aufnahme der integrierten Wechselspannung (U9) durch das Abtast- und Halteglied (93) während der Wiedergabe von empfangenen Sprachsignalen über den Lautsprecher (70) verhindert.

17. Schaltungsanordnung nach Anspruch 14, dadurch gekennzeichnet, daß dem integrierten Ausgangssiganl (U3G) des Abtast- und Haltegliedes (93) eine Referenzspannung (Uref) hinzuaddiert wird, durch die eine kleinste Maximallautstärke an dem Lautsprecher (70) festgelegt wird.

18. Schaltungsanordnung nach Anspruch 11, dadurch gekennzeichnet, daß ein von einem Meßmikrofon (111) aufgrund des Umgebungsgeräusches erzeugtes Meßsignal als Stellgröße für die Steuerschaltung (110) dient.

19. Schaltungsanordnung nach Anspruch 18, dadurch gekennzeichnet, daß das Ausgangssignal des Meßmikrofons (111) verstärkt und einem Addierglied (114) zugeführt wird, an das auch die Sprachsignale, die von dem Teilnehmer und die von dem Lautsprecher (70) erzeugt werden, negiert angelegt werden.

20. Schaltungsanordnung nach Anspruch 11, dadurch gekennzeichnet, daß ein von dem Fahrzustand eines Kraftfahrzeuges abhängiges Meßsignal als Stellgröße für die Steuerschaltung (120) dient.

**Claims**

1. A circuit arrangement for controlling the dynamic range of voice signals in a communication terminal, comprising

- a microphone (50) connected to a transmission channel via a send path,
- a loudspeaker (70) connected to the transmission channel via a receive path, and
- a control unit determining the gain imparted to the signals in the send path,

**characterized in**

that the microphone (50) is followed by a controllable compandor (52) in which the signal voltages (U1) supplied by the microphone (50)

A. are attenuated to a uniform signal level if they lie above a predetermined value (Ue min),

B. are amplified if they lie below the predetermined value (Ue min), and

c. are imparted maximum gain if they have the predetermined value (Ue min).

2. A circuit arrangement as claimed in claim 1, characterized in that the predetermined value (Ue min) of the signal voltages is set by means of a volume control (14, 64) by which the user varies the loudness of the loudspeaker (4, 70).

3. A circuit arrangement as claimed in claim 1, characterized in that the compandor (52) contains a compressor (53 to 58) which includes an operational amplifier (54) and a multiplier (55) inserted in the feedback loop of the operational amplifier (54) and having a control signal applied to its control input which, depending on the level of the microphone signal voltage (U1), is determined either by the rectified microphone signal (U1) or by a DC voltage (U8) from the volume control (64) on which a rectified AC voltage (-U9) derived from the output voltage (U2) of the compandor (52) is superimposed.

4. A circuit arrangement as claimed in claim 3, characterized in that the output signal (U2) from the compandor (52) is freed from its DC voltage components in a high-pass filter (61), rectified in a full-wave rectifier (62), and superimposed on the DC voltage (U8) from the volume control (64) in an adder (63).

5. A circuit arrangement as claimed in claim 4, characterized in that the DC voltage signal (U7) delivered by the adder (63) is applied to a low-pass filter (65) in which the average (U6) of said rectified AC voltage signal is taken.

6. A circuit arrangement as claimed in claim 1, characterized in

- that the compandor consists of a compressor (6) and an expander (7),
- that in the compressor (6), those signal voltages from the microphone (1) which lie above the predetermined value are attenuated to a uniform level by changing the gain,
- that the signals delivered by the compressor are fed to the expander (7), by which the signal voltages lying below the predetermined value are imparted a gain which decreases with decreasing signal level, and
- that the gain of the compressor (6) assumes a maximum value for signal voltages having the predetermined value.

7. A circuit arrangement as claimed in claim 6, characterized in that the compressor (6) contains an operational amplifier (18) and a multiplier (20) inserted in the feedback loop of the operational amplifier (18) and having the rectified microphone signal (Ue) applied to its control input (25).

8. A circuit arrangement as claimed in claim 7, characterized in that the output of the send path (2) is connected via a coupling stage (30) to a summing stage (28) of the compressor (6).

9. A circuit arrangement as claimed in claim 8, characterized in that the coupling stage (30) contains an element with an exponential characteristic.

10. A circuit arrangement as claimed in claim 6, characterized in that an equalizer (8) suppressing the resonance ranges of the electroacoustic transducer system is connected ahead of the expander (7).

11. A circuit arrangement as claimed in claim 1, characterized in that the predetermined value (Ue min) of the signal voltages is set by a control circuit (90) as a function of the ambient noise.

12. A circuit arrangement as claimed in claim 11, characterized in that the signal-to-noise ratio of the voice signal (U2) provided at the output of the send path (2) is maintained constant by the control circuit (90).

13. A circuit arrangement as claimed in claim 11, characterized in that a rectified AC voltage

(U9) derived from the output voltage (U2) of the send path (2) serves as a manipulated variable for the control circuit (90).

14. A circuit arrangement as claimed in claim 13, characterized in that the control circuit (90) includes a sample-and-hold device (93) to which the rectified AC voltage (U9) is applied through an integrator (92) and whose integrated output ($U_{3G}$) is applied to the control input (63) of the compandor (52).

15. A circuit arrangement as claimed in claim 13, characterized in that the control circuit (90) includes a first blocking circuit (94, 95, 96) which prevents the integrated AC voltage (U9) from being received by the sample-and-hold device (93) while the user is talking.

16. A circuit arrangement as claimed in claim 13, characterized in that the control circuit (90) includes a second blocking circuit (98, 99, 100) which prevents the integrated AC voltage (U9) from being received by the sample-and-hold device (93) during the reproduction of received voice signals via the loudspeaker (70).

17. A circuit arrangement as claimed in claim 14, characterized in that a reference voltage (Uref) determining the lowest maximum volume at the loudspeaker (70) is added to the integrated output signal ($U_{3G}$) from the sample-and-hold device (93).

18. A circuit arrangement as claimed in claim 11, characterized in that a measurement signal produced by a measuring microphone (111) in response to the ambient noise serves as a manipulated variable for the control circuit (110).

19. A circuit arrangement as claimed in claim 18, characterized in that the output of the measuring microphone (111) is amplified and fed to an adder (114) to which the voice signals produced by the user and by the loudspeaker (70) are applied in negated form.

20. A circuit arrangement as claimed in claim 11, characterized in that a measurement signal representative of the operating state of a motor vehicle serves as a manipulated variable for the control circuit (120).

**Revendications**

1. Disposition de circuit pour la gestion de la dynamique de signaux vocaux dans un terminal de télécommunications, disposition présentant les caractéristiques suivantes:
- un microphone (50) qui est relié à un canal de transmission par l'intermédiaire d'une dérivation d'émission,
- un haut-parleur (70) relié avec le canal de transmission par l'intermédiaire d'une dérivation de réception et
- un organe de gestion qui détermine l'amplification des signaux dans la dérivation d'émission,
    disposition de circuit caractérisée par le fait que
- en aval du microphone (50) est monté un compresseur-expanseur pilotable (52) de la dynamique, dans lequel les tensions du signal fournies par le microphone (U1),
A. dans la mesure où elles se situent au-dessus d'une valeur prescrite (Uemin), sont comprimées pour être ramenées à un niveau homogène du signal,
B. dans la mesure où elles se situent en dessous de la valeur prescrite (Uemin), sont expansées et
C. dans la mesure où elles présentent la valeur prescrite sont amplifiées au maximum.

2. Disposition de circuit selon la revendication 1, caractérisée par le fait que la valeur prescrite (Uemin) des tensions du signal est déterminée au moyen d'un dispositif réglant (14, 64) avec lequel l'abonné règle la puissance sonore du haut-parleur (4, 70).

3. Disposition de circuit selon la revendication 1, caractérisé par le fait que le compresseur-expanseur (52) de la dynamique contient un compresseur (53 à 58) de la dynamique qui présente un amplificateur opérationnel (54) et un multiplicateur (55) qui est situé sur la dérivation de rétroaction de cet amplificateur et à l'entrée de commande duquel est amené un signal de commande qui est déterminé, en fonction du niveau de la tension (U1) du signal du microphone, soit par le signal du microphone (U1) redressé, soit par une tension continue (U8) qui est fournie par le dispositif réglant (64) et à laquelle se superpose une tension alternative (-U9) redressée, dérivée de la tension de sortie (U2) du compresseur-expanseur (52).

4. Disposition de circuit selon la revendication 3, caractérisée par le fait que le signal de sortie (U2) est séparé, dans un filtre passe-haut (61), d'avec ses composantes de tension continue, puis redressé dans un redresseur pleine onde (62) et, dans un circuit d'addition (63), superposé à la tension continue (U8) fournie par le dispositif réglant (64).

5. Disposition de circuit selon la revendication 4, caractérisée par le fait que le signal de tension continue (17) fourni par le circuit d'addition (63) est envoyé sur un filtre passe-bas (65) dans lequel se forme la valeur moyenne (U6) du signal de tension alternative redressée superposé.

6. Disposition de circuit selon la revendication 1, caractérisée
   - par le fait que le compresseur-expanseur de la dynamique est constitué d'un compresseur de la dynamique (6) et d'un expanseur de la dynamique (7),
   - par le fait que dans le compresseur de la dynamique (6), les tensions du signal, fournies par le microphone (1), qui se situent au-dessus de la valeur prescrite, sont comprimées à un niveau du signal homogène par modification du facteur d'amplification,
   - par le fait que les signaux émis par le compresseur de la dynamique sont amenés à l'expanseur de la dynamique (7) par lequel les tensions du signal qui se situent en dessous de la valeur prescrite sont amplifiées avec un facteur d'amplification qui décroît lorsque le niveau du signal décroît, et
   - par le fait que le facteur d'amplification du compresseur de la dynamique (6) prend une valeur maximale pour les tensions du signal qui présentent la valeur prescrite.

7. Disposition de circuit selon la revendication 6, caractérisée par le fait que le compresseur de la dynamique (6) comporte un amplificateur opérationnel (18) et un multiplicateur (20) qui est situé dans la dérivation de rétroaction de l'amplificateur et à l'entrée de commande (25) duquel est amené le signal du microphone redressé (Ue).

8. Disposition de circuit selon la revendication 7, caractérisé par le fait que la sortie du chemin d'émission (2) est reliée, par l'intermédiaire d'un réseau de couplage (30), avec un étage d'addition (28) du compresseur (6).

9. Disposition de circuit selon la revendication 8, caractérisée par le fait que le réseau de couplage (30) présente un élément à caractéristique exponentielle.

10. Disposition de circuit selon la revendication 6, caractérisée par le fait qu'en avant de l'expanseur de la dynamique (7) est disposé un correcteur de distorsion (8) qui supprime les plages de résonance du système transducteur acoustique (1).

11. Disposition de circuit selon la revendication 1, caractérisée
    - par le fait que la valeur prescrite (Uemin) des tensions du signal est réglée par un circuit de commande (90) en fonction des bruits ambiants.

12. Disposition de circuit selon la revendication 11, caractérisée par le fait que le rapport signal-bruit du signal vocal (U2) émis à la sortie de la dérivation d'émission (2) est maintenu constant par le circuit de commande (90).

13. Disposition de circuit selon la revendication 11, caractérisée par le fait qu'une tension alternative redressée (19), dérivée de la tension de sortie (U2) du chemin d'émission (2) sert de grandeur réglante pour le circuit de commande (90).

14. Disposition de circuit selon la revendication 13, caractérisée par le fait que le circuit de commande (90) contient un élément échantillonneur (93) auquel la tension alternative redressée (19) est amenée par l'intermédiaire d'un élément intégrateur (92) et dont le signal de sortie intégré (U3G) est amené à l'entrée de commande (63) du compresseur-expanseur de la dynamique (52).

15. Disposition de circuit selon la revendication 13, caractérisée par le fait que le circuit de commande (90) contient un premier circuit de blocage (94, 95, 96), qui interdit à l'élément échantillonneur (93) de prélever la tension alternative intégrée (U9) pendant que l'abonné parle.

16. Disposition de circuit selon la revendication 13, caractérisée par le fait que le circuit de commande (90) contient un second circuit de blocage (98, 99, 100) qui interdit à l'élément échantillonneur (93) de prélever la tension alternative intégrée (U9) pendant la restitution, par l'intermédiaire du haut-parleur (70) des signaux vocaux reçus.

17. Disposition de circuit selon la revendication 14, caractérisée par le fait que l'on ajoute au signal de sortie intégré (U3G) de l'élément échantillonneur (93) une tension de référence (Uref) au moyen de laquelle est fixée pour le haut-parleur (70) sa plus petite puissance sonore maximale.

18. Disposition de circuit selon la revendication 11, caractérisée par le fait que c'est un signal de mesure produit par un microphone de mesure (111) sur la base du bruit ambiant qui sert de grandeur réglante pour le circuit de commande (70).

19. Disposition de circuit selon la revendication 18, caractérisée par le fait que le signal de sortie du microphone de mesure (11) est amplifié et amené à un élément additionneur (114) auquel sont également amenés, avec le sign négatif, les signaux vocaux qui sont produits par l'interlocuteur et ceux qui sont produits par le haut-parleur (70).

20. Disposition de circuit selon la revendication 11, caractérisée par le fait que c'est un signal de mesure dépendant de la vitesse de circulation d'un véhicule qui sert de grandeur réglante pour le circuit de commande (120).

Fig.1

EP 0 290 952 B1

Fig.2

Fig.3

FIG.4

FIG.5

Fig.6

EP 0 290 952 B1

Fig.7

Fig.8

Fig.9

Fig.10

f = f (U11)

Fig.11

Fig. 12

EP 0 290 952 B1

Fig.13

Fig.14

EP 0 290 952 B1

Fig. 15

Fig. 16

Fig. 17